# EUROPÄISCHE PATENTSCHRIFT

(11) **EP 3 682 255 B1**
(45) Veröffentlichungstag und Bekanntmachung des Hinweises auf die Patenterteilung: **02.04.2025**
(21) Anmeldenummer: 18769698.4
(22) Anmeldetag: 14.09.2018
(51) Int. Cl.: G01R 31/3185

(54) **MICROCHIP MIT EINER VIELZAHL VON REKONFIGURIERBAREN TESTSTRUKTUREN**
MICROCHIP HAVING A PLURALITY OF RECONFIGURABLE TEST STRUCTURES
MICROPUCE COMPORTANT UNE PLURALITÉ DE STRUCTURES D'ESSAI RECONFIGURABLES

(30) Priorität: 15.09.2017 DE 102017216444
(43) Veröffentlichungstag der Anmeldung: 22.07.2020
(73) Patentinhaber: Technische Hochschule Wildau, 15745 Wildau (DE)
(72) Erfinder: KRENZ-BAATH, René, 59063 Hamm (DE)
(74) Vertreter: RCD-Patent Giesen, Schmelcher & Griebel Patentwanwälte PartG mbB
(86) Internationale Anmeldenummer: PCT/EP2018/074898
(87) Internationale Veröffentlichungsnummer: WO 2019/053196

(56) Entgegenhaltungen:
- US-A1- 2004 153 921
- US-A1- 2013 086 441
- US-B1- 8 533 546

## Beschreibung

Die Erfindung betrifft einen Microchip mit einer Vielzahl von rekonfigurierbaren Teststrukturen.

### Hintergrund

Es ist bekannt Microchips mit Teststrukturen auszustatten. Diese Teststrukturen erlauben es Microchips nach der Produktion zu testen. Testen kann sich dabei auch auf einzelne Komponenten des Microchips beziehen.

Bei den bisher bekannten Teststrukturen wird über einen Zugang Testsignale angelegt und durch alle Strukturen hindurchgeleitet. In aller Regel steht nur ein Testzugang zur Verfügung, da die Fläche, die für Zugänge zur Verfügung steht limitiert ist. Dies führt in der Folge dazu, dass Tests u.U. lange andauern können, wenn sie mit der gebotenen Sorgfalt ausgeführt werden.

Es zeigt sich jedoch, dass solche Tests häufig nur unzureichend durchgeführt werden, da sie einen erheblichen Zeitaufwand darstellen. Zusätzlich wird auch ein hohes Datenvolumen generiert, das in der Analyse ebenfalls aufwändig ist. Beides zusammen führt jeweils zu einem erhöhten Kostenaufwand.

Solche Tests und Test-Strukturen werden nur während des Produktionstestes verwendet (Sogenannter In-Production-Test) und machen einen nicht zu vernachlässigenden Teil von bis zu 50 % der Gesamtkosten aus.

Beispielsweise ist aus der US Patentanmeldung US 2013 / 086 441 A1 ein selbstkonfigurierbare Verkettung von TAP Controllern bekannt.

Zugleich ist aber festzustellen, dass in vielen Bereichen auch während des Betriebs von Microchips Tests (Sogenannte In-Field-Tests) wünschenswert oder gar normativ gefordert sind.

Beispielsweise fordert die Norm ISO 26262 einen schnellen Selbsttest im Betrieb (Sogenannte In-Field-Test).

Die Bereitstellung solcher Tests wird insbesondere in Bereichen einer autonomen Steuerung, wie z.B. dem autonomen Fahren, eine Notwendigkeit werden, um die Betriebssicherheit und damit auch die Sicherheit für andere zu ermöglichen.

Solche in-Field-test erfordern jedoch häufig zusätzliche Intrastruktur und zusätzliche Kosten, da für den Test im laufenden Betrieb zusätzliche Sicherheitsfunktionen zu berücksichtigen sind, da der eigentliche Betrieb / Funktion des Microchips nicht beeinträchtigt werden darf.

Typischerweise wird ein Microchip als ein Design-under-Test (oder mehrere Designs-under-Test) angesehen. Dieses Design-under-Test wird mit zusätzlichen Teststrukturen versehen, welche unabhängig von der eigentlich zur Verfügung gestellten Funktionalität des Microchips / des Designs-under-Test Möglichkeiten der Kontrollierbarkeit / Observierbarkeit bereitstellt.

Hierzu wird der i.d.R. Microchip mit einem Testdateneingang TDI und einem Testdatenausgang TDO und einem Testtaktsignal ausgestattet. Das Testtaktsignal kann auch aus anderen Taktsignalen abgeleitet sein. Häufig ist das Testtaktsignal geringer als die maximalen Taktsignale, die auf dem Microchip Verwendung finden.

Zwischen dem Testdateneingang TDI und dem Testdatenausgang TDO sind als Teststrukturen Speicherzellen angeordnet, die als FIFO (First in First out) - Kette zwischen dem Testdateneingang TDI und dem Testdatenausgang TDO verstanden werden kann.

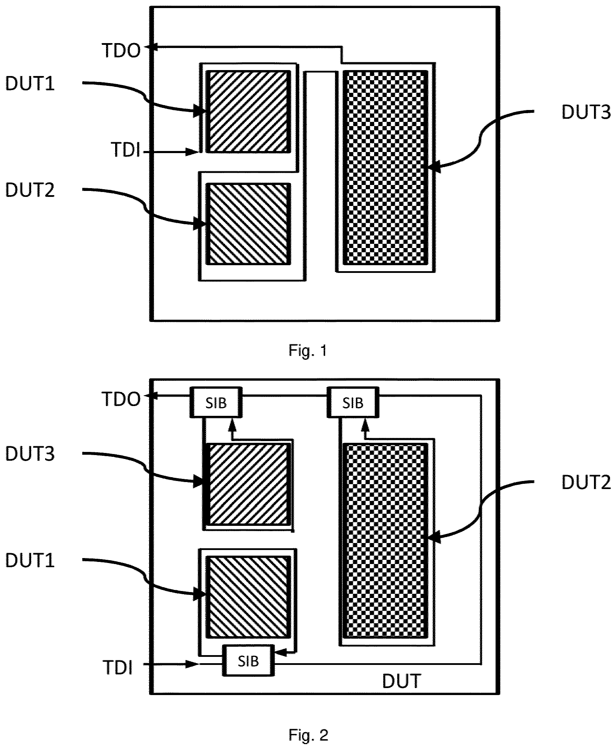

In einem solchen Ansatz wird für alle Elemente ein gemeinsamer Teststimulus (nur Testdaten) über den Testeingang TDI eingebracht und durch die Teststruktur durchgetaktet und am Testausgang TDO das Ausgangssignal (Verarbeitete Testdaten) ausgelesen. Dieser Ansatz bildet eine feste Scan-Kette, d.h. der Ablauf der Tests bzw. der zu testenden Strukturen ist fest vorgegeben. Eine solche beispielhafte Scan-Kette ist in Figur 1 dargestellt. Hier muss ein über TDI eingebrachter Teststimulus zunächst durch die von links unten nach rechts oben schraffierte Teststruktur DUT1 laufen, anschließend durch die von rechts unten nach links oben schraffierte Teststruktur DUT2, danach durch die schachbrettartig schraffierte Teststruktur DUT3 laufen, um abschließend am Testausgang TDO verarbeitet zur Vorschein zu gelangen.

Mithilfe dieser Infrastruktur werden Testdaten in das DUT eingebracht und gleichzeitig Testresultate i.A. in Form einer Bitreihen über den TDO abgeführt, siehe Figur 1. In komplexen DUTs können Shift-Ketten oft eine Länge von mehreren tausend Speicherelementen übersteigen.

Auf diese Shift-Ketten werden abhängig vom jeweiligen Testmodus mehrere tausend Testvektoren angewendet, wobei jeder Testvektor aus einer Bitfolge mit der Länge gleich der Länge der Shift-Kette besteht.

Teststimuli bzw. Testresultate sind in den sequentiell von TDI eingeschobenen bzw. nach TDO herausgeschobenen Bitfolgen enthalten.

Solche linearen Strukturen haben sich jedoch als unflexible erwiesen, da sie nur mit einer einheitlichen Länge des Teststimulus und ohne die Möglichkeit der Testmodi ausgestattet ist.

Um dies zu umgehen, wurde in der Vergangenheit bereits begonnen sogenannte konfigurierbare Scan-Ketten vorzuschlagen. Bei diesen besteht der Teststimulus eingangsseitig aus Testdaten und Steuerdaten, mit denen ein bestimmter Bereich der Teststruktur getestet werden kann. Diese konfigurierbaren Scanketten erlauben eine flexiblere Testdurchführung und z.B. im Fehlerfall eine schnellere Reaktionszeit.

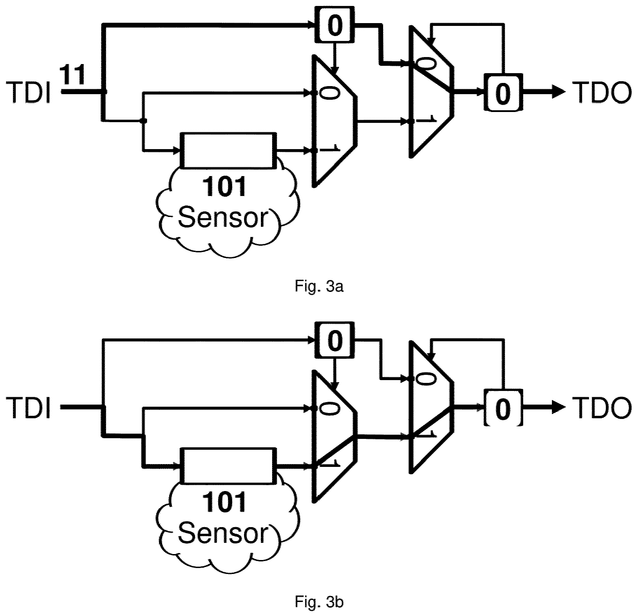

Am Beispiel der Figur 2 sei eine konfigurierbare Scan-Kette verdeutlicht. Hier sind zusätzliche Elemente SIB eingebracht, die es erlauben bestimmte Strukturen des Design-under-Test gezielt anzusteuern. Wollte man z.B. in einer Anordnung gemäß Figur 1 nur die erste Struktur DUT1 testen, so müsste dennoch der gesamte Test auch durch DUT2 und DUT3 geführt werden. In Figur 3 hingegen kann z.B. durch ein 3bit Steuersignal die zu testende Struktur ausgewählt werden. Beispielsweise kann durch 100 die Struktur DUT1 für einen Test ausgewählt sein, während 101 die Strukturen DUT1 Und DUT 3 auswählt. Der (nachfolgende) Teststimulus wird sodann an die ausgewählten Strukturen weitergeleitet, sodass die Testung flexibler und damit schneller möglich ist. Eine solche Vorgehensweise entspricht u.a. / beispielsweise IEEE Standard 1687.

Es hat sich jedoch gezeigt, dass die bei großen und/oder komplexen Teststrukturen dieser Ansatz mit erheblichen Nachteilen verbunden ist. Zum einen, wenn das Design-under-test mehrere Hierarchie-Ebenen aufweist und/oder komplexere Kontrollstrukturen, sind mehrere Konfigurationszyklen notwendig, um eine bestimmte Testung zu ermöglichen. Somit steigt mit jedem Konfigurationszyklus auch die notwendige Testzeit an. Häufig werden daher solche Tests in der Hierarchie tieferliegender Strukturen weniger gut getestet, um den Zeitnachteil auszugleichen. Ein solches Beispiel ist in den Figuren 3a und 3b aufgezeigt. Um in der Aufgezeigten Teststruktur das Datum des Sensors auszulesen, muss zunächst in einem ersten Schritt der obere Ast mit der Bitfolge "00" ausgewählt werden. Sodann können mittels der Bitfolge "11" die Multiplexer so angesteuert werden, dass in dem nachfolgenden Ausschiebeschritten, das Sensordatum "101" durch Einschieben von entsprechenden Werten (Teil des Teststimulus) auf dem Eingang TDI aus dem Ausgang TDO ausgeschoben werden.

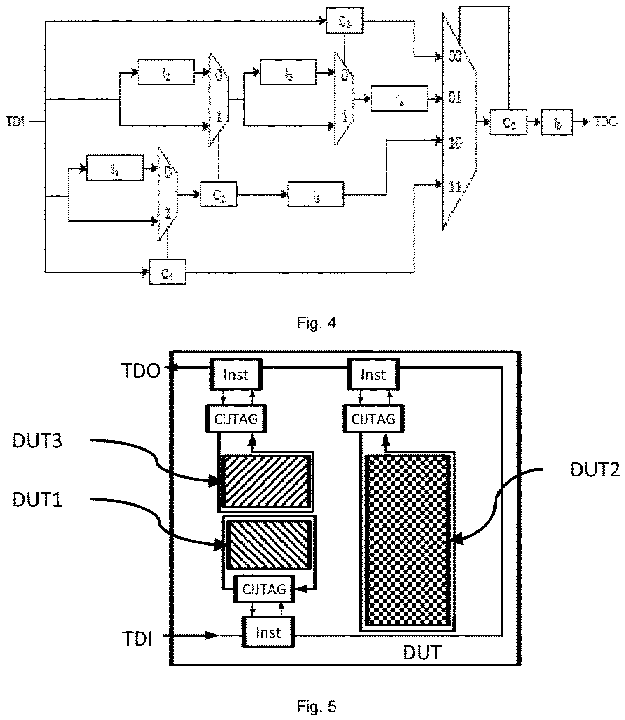

Weiterhin zeigt sich, dass die Teststrukturen bei einer Mehrzahl von Hierarchien auch sich ausschließende Unterstrukturen aufweisen können, siehe hierzu Figur 4. Hier können die Teststruktur I4 und I5 nur nacheinander aktiviert werden, d.h. es wird mindestens ein weitere Konfigurationsschritt benötigt. Die Wahrscheinlichkeit solcher sich ausschließender Teststrukturen steigt mit der Komplexität. Insofern ist die Flexibilität entweder eingeschränkt oder führt zu einer gesteigerten Komplexität, da sich ausschließende Unterstrukturen häufig nur durch Einfügung zusätzlicher Hierarchie-Ebenen zugänglich werden.

### Aufgabe

Ausgehend davon ist es eine Aufgabe der Erfindung einen Microchip mit Teststrukturen bereitzustellen, der ein Problem oder mehrere Probleme aus dem Stand der Technik löst bzw. der sowohl schnelle In-Field als auch schnelle In-Production-Tests ermöglicht.

### Kurzdarstellung der Erfindung

Die Aufgabe wird gelöst durch einen Microchip gemäß Anspruch 1.

Weitere vorteilhafte Ausgestaltungen sind Gegenstand der abhängigen Ansprüche, der Figuren und der ausführlichen Beschreibung.

### Kurzdarstellung der Figuren

Nachfolgend wird die Erfindung näher unter Bezugnahme auf die Figuren erläutert werden. In diesen zeigt:
Fig. 1 eine schematische Übersicht von Teststrukturen gemäß dem Stand der Technik,
Fig. 2 eine schematische Übersicht von Teststrukturen gemäß dem Stand der Technik,
Fig. 3a und 3b schematische Übersichten des Signalweges in einer Teststruktur gemäß dem Stand der Technik in zwei aufeinanderfolgenden Konfigurationsschritten,
Fig. 4 eine weitere schematische Übersicht von Teststrukturen gemäß dem Stand der Technik,
Fig. 5 eine schematische Übersicht von Teststrukturen gemäß Ausführungsformen der Erfindung,
Fig. 6 und 7 einen Aspekt gemäß Ausführungsformen der Erfindung,
Fig. 8 einen weiteren Aspekt gemäß Ausführungsformen der Erfindung,
Fig. 9 noch einen weiteren Aspekt gemäß Ausführungsformen der Erfindung,
Fig. 10 schematische Übersichten gemäß Ausführungsformen der Erfindung ,und
Fig. 11 schematische Übersichten gemäß Ausführungsformen der Erfindung.

### Detaillierte Beschreibung

Nachfolgend wird die Erfindung eingehender unter Bezugnahme auf die Figur dargestellt werden. Dabei ist anzumerken, dass unterschiedliche Aspekte beschreiben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

In den Figuren 5-11 sind Ausführungsformen der Erfindung dargestellt. Dabei weist ein erfindungsgemäßer Microchip eine Vielzahl von rekonfigurierbaren Teststrukturen DUT1,...DUT4 auf. Die Anzahl der rekonfigurierbaren Teststrukturen ist nicht beschränkt und lediglich mit 4 Teststrukturen in einzelnen Figuren beispielhaft.

Die Gesamtheit der Teststrukturen werden über einen gemeinsamen Testeingang TDI angesprochen und aus einem gemeinsamen Testausgang TDO ausgelesen. D.h. der Microchip verfügt über einen Testeingang TDI und einen Testausgang TDO, wobei die Vielzahl von Teststrukturen mit dem Testeingang TDI und dem Testausgang TDO verbindbar sind. Für jede der Vielzahl von Teststrukturen ist ein Zwischenspeicher CSU0... CSU3 vorgesehen. Die Größe des Zwischenspeichers kann je nach Teststruktur DUT1... DUT4 unterschiedlich ausgestaltet sein.

Jede der Vielzahl von Teststrukturen DUT1... DUT4 kann nunmehr getrennt als auch nebenläufig unter Zuhilfenahme des jeweiligen Zwischenspeichers CSU0... CSU3 getestet werden.

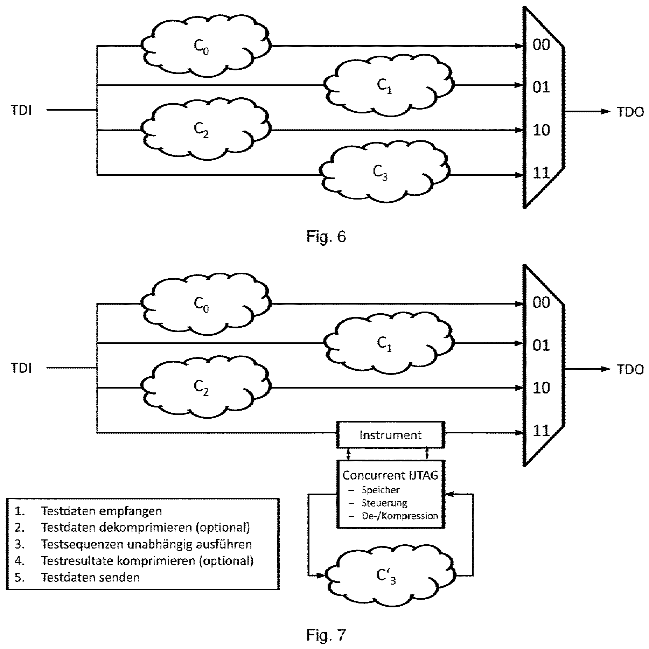

Nebenläufig bedeutet dabei, dass verschiedene, insbesondere sich ausschließende, Bereiche der Testinfrastruktur (z.B. C₁ und C₂ in Figur 6) unabhängig voneinander genutzt werden können.

Beispielsweise soll in Figur 5 DUT3 getestet werden. DUT3 korrespondiert in den nachfolgenden Figuren zu C3. Dann ist DUT3 ebenso wie die anderen Teststrukturen DUT1, DUT2 an einem gemeinsamen Testbus (von TDI nach TDO) angeschlossen. Allerdings ist dieser Anschluss über ein Instrument - abgekürzt INST - hergestellt. Dem Instrument folgend befindet sich eine Einheit CIJTAG (Concurrent IJTAG), die den eigentlichen Test innerhalb einer zu testenden Struktur DUT1 ... DUT3 kontrolliert.

D.h. die Tests bzw. die Steuerung der Testinfrastruktur können eigenständig ablaufen, sodass ein Ablauf eines Testes in der Struktur DUT1 nicht die Konfiguration eines anderen Testes in einer anderen Teststruktur DUT2, DUT3 behindert, bzw. während ein Test abläuft, Testergebnisse einer oder mehrerer anderer Strukturen ausgelesen werden können. D.h. in der Erfindung erfolgt eine Logikverlagerung auf die Strukturebene, sodass Test-/Steuerdaten für mehrere Testsequenzen in der Unterstruktur in einem Block geladen werden können. Allerdings können die Tests auch parallel instrumentiert werden. D.h. durch eine geeignete Ansteuerung der Instrumente können Tests parallel geladen werden.

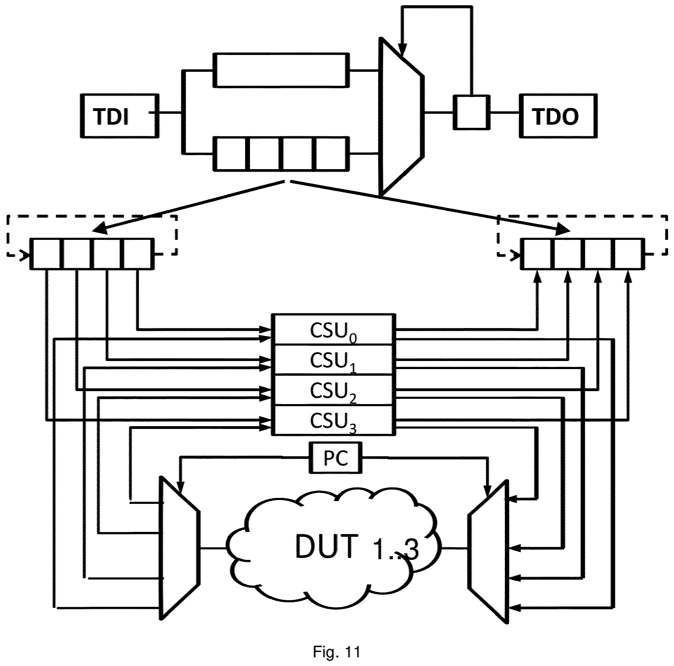

Eine beispielhafte Infrastruktur ist in Figur 11 skizziert. Hier werden Teststimuli und/oder Testresultate in einem Zwischenspeicher CSU0 .... CSU3 gespeichert. Weiterhin kann für die Abarbeitung des Testes zusätzlich noch ein Ablaufzähler PC vorgesehen sein. Im Prinzip hat der CIJTAG-Block (siehe Figur 5) die Aufgaben Testdaten und Testresultate temporär zu speichern, den Testablauf, die (optionale) Testdatendekomprimierung, und die (optionale) Testresultatkomprimierung innerhalb der jeweiligen Teststruktur zu steuern. Natürlich kann der Block CIJTAG auch noch weitere Funktionen übernehmen.

D.h. wenn in Figur 6 die Struktur C3 zu testen ist, so wird sie mit Test- und Steuerdaten versorgt. Hierzu nimmt das Instrument in Figur 7 bei Erkennen der Auswahl die Testdaten entgegen und stellt sie dem Block CIJTAG zur Verfügung. Empfangene Testdaten enthalten wiederum Steuerdaten für einen Test. Sind solche Steuerdaten enthalten, so steuert der Block CIJTAG die Teststruktur entsprechend an. Teststimulus bzw. Teststimuli, welche in den Testdaten enthalten sind, werden dann unter Steuerung durch den der Block CIJTAG ausgeführt. Testresultate werden durch den Block CIJTAG gesammelt und bei erneuter Ansteuerung an das Instrument zur Verfügung gestellt und über den Ausgang TDO ausgelesen.

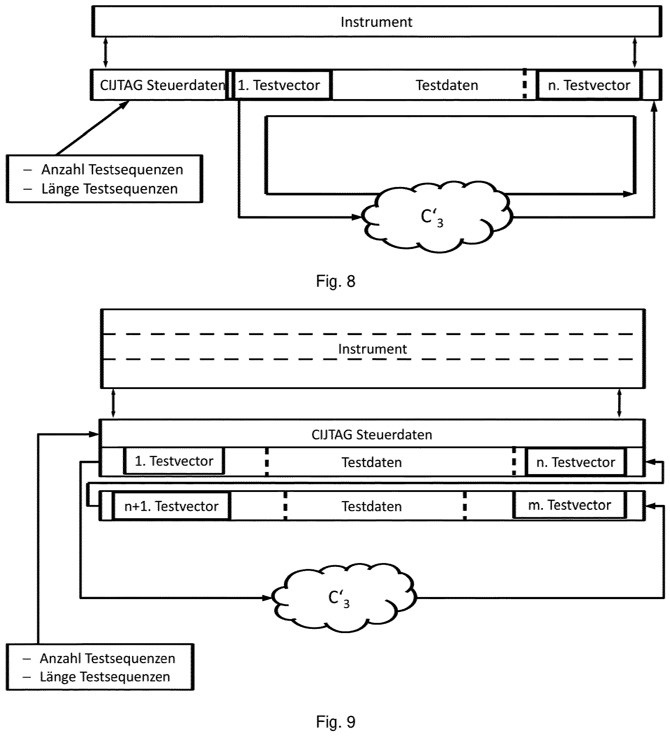

In Figur 8 sind beispielsweise CIJTAG Steuerdaten und Teststimuli (sogenannte Testvektoren) enthalten. Die CIJTAG Steuerdaten können z.B. Daten betreffend der Anzahl der Testsequenzen und/oder der Länge der Testsequenzen enthalten.

Ohne Beschränkung der Allgemeinheit kann wie in Figur 9 gezeigt auch vorgesehen sein, dass ein multi-Bit Bus eingesetzt wird, d.h. es werden unterschiedliche Tests (im Beispiel ein Test mit Testvektoren 1..n und ein anderer Test mit Testvektoren n+1...m durchgeführt.

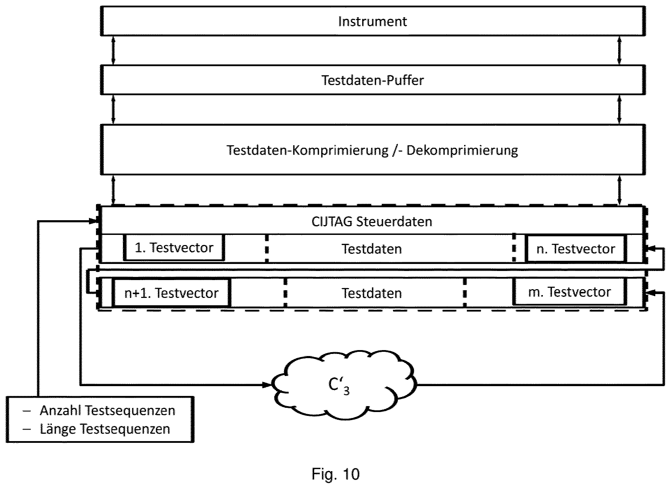

Ohne Beschränkung der Allgemeinheit kann wie in Figur 10 gezeigt, vorgesehen sein, dass Testdaten zunächst in einen Zwischenspeicher/Testdaten-Puffer eingelesen werden und vor der Abarbeitung dekomprimiert werden. Dabei können auch nur Teile der Daten komprimiert sein. Beispielsweise können die Steuerdaten un-komprimiert sein während die Teststimuli komprimiert sind oder umgekehrt.

In gleicher Weise kann jedoch auch vorgesehen sein, dass die Testresultate komprimiert werden, bevor sie über das Instrument aus dem Testdatenpuffer ausgelesen und über TDO ausgelesen werden.

Kompression erlaubt eine Reduzierung der Testdatenmenge und somit Zeitvorteile beim Transport der Daten, sodass Tests beschleunigt konfiguriert werden können und/oder beschleunigt ausgelesen werden können. Insbesondere dadurch dass das Ein- und Auslesen von Daten in vielen Fällen über einen nur 1-bit breiten Eingang TDI / Ausgang TDO erfolgt ist hier die Reduktion signifikant. D.h. während eine Teststruktur Daten (de-)komprimiert können andere Teststrukturen geladen / entladen werden.

Es sei dabei angemerkt, dass die Kompression/Dekompression auch optional konfigurierbar gestaltet sein kann. Z.B. kann durch die Steuerdaten signalisiert werden, ob und gegebenfalls welche Daten zu (de-)komprimieren sind.

Weiterhin kann vorgesehen sein, dass die Teststruktur einen In-Field-Test zur Verfügung stellt.

Ohne weiteres kann in Ausführungsformen der Erfindung zudem vorgesehen sein, dass zumindest ein Teil der Vielzahl von Teststrukturen zeitgleich getestet werden kann.

Durch die Erfindung wird es ermöglicht, dass nebenläufige und rekonfigurierbare Testinfrastrukturen für den In-Production-Test möglich sind. Im Vergleich zu bisherigen Strukturen bieten die erfinderischen Teststrukturen die Möglichkeit Komponenten mit einem signifikant geringeren Zeitaufwand/Datenaufwand zu testen. Hierdurch kann neben der erzielten Zeitersparnis weiterhin auch die Testqualität verbessert werden, da nunmehr unterbliebene Test innerhalb der bisherigen benötigten Zeit erfolgen können.

Dieser Vorteil ist auch bei komplexeren und zeitgleich kleiner werdenden Strukturen auf Mikrochips von höchster Wichtigkeit.

Insbesondere für in-Field-Tests erlaubt die Erfindung die Möglichkeit die Vorgaben moderner Normen wie z.B. ISO26262 zu erfüllen, welche z.B. einen Selbsttest im Bereich von Millisekunden fordert. Hier ist es durch die Nebenläufigkeit möglich zahlreiche Testoperationen unabhängig und gleichzeitig zu steuern bzw. durchzuführen.

## Patentansprüche

1. Microchip mit einer Vielzahl von rekonfigurierbaren Teststrukturen, wobei der Microchip über einen Testeingang (TDI) und einen Testausgang (TDO) verfügt, wobei die Vielzahl von Teststrukturen (DUT1 ... DUT3) mit dem Testeingang (TDI) und dem Testausgang (TDO) verbindbar sind, **dadurch gekennzeichnet, dass** für jede der Vielzahl von Teststrukturen (DUT1 ... DUT3) ein Zwischenspeicher vorgesehen ist, wobei der Zwischenspeicher im Betrieb Steuerdaten und Teststimuli enthält, wobei jede der Vielzahl von Teststrukturen getrennt und nebenläufig unter Zuhilfenahme des jeweiligen Zwischenspeichers getestet werden kann, wobei jede Teststruktur ein Instrument aufweist, wobei dem Instrument folgend sich eine Einheit CIJTAG befindet,, die den eigentlichen Test innerhalb der betreffenden Teststruktur (DUT1 ... DUT3) kontrolliert.

2. Microchip nach Anspruch 1, **dadurch gekennzeichnet, dass** ein Teststimulus, der in einen der Zwischenspeicher eingelesen wird vor Abarbeitung dekomprimiert wird.

3. Microchip nach Anspruch 1 oder 2, **dadurch gekennzeichnet, dass** das Ergebnis eines Teststimulus, in einen der Zwischenspeicher eingelesen wird und vor Weiterleitung an den Testausgang (TDO) komprimiert wird.

4. Microchip nach einem der vorhergehenden Ansprüche, **dadurch gekennzeichnet, dass** die Teststruktur für die Verwendung in einem In-Field-Test geeignet ist.

5. Microchip nach einem der vorhergehenden Ansprüche, **dadurch gekennzeichnet, dass** der Microchip dazu eingerichtet ist, dass zumindest ein Teil der Vielzahl von Teststrukturen zeitgleich getestet werden kann.

## Claims

1. A microchip comprising a multiplicity of reconfigurable test structures, wherein the microchip comprises a test input (TDI) and a test output (TDO), whereby the multiplicity of reconfigurable test structures (DUT1 ... DUT3) are connectable to the test input (TDI) and to the test output (TDO), **characterized in that** for each of the multiplicity of reconfigurable test structures (DUT1 ... DUT3) a buffer memory is provided, whereby the buffer memory in operation comprises control data and test stimuli, whereby each of the multiplicity of reconfigurable test structures may be tested separately and concurrently with the aid of the respective buffer memory, whereby each test structure comprises an instrument, whereby downstream to the instrument a unit CIJTAG is arranged, which controls the actual test within the respective test structure (DUT1 ... DUT3).

2. Microchip according to claim 1, **characterized in that** a test stimulus, which is loaded into the buffer memory, is decompressed prior to execution.

3. Microchip according to claim 1 or 2, **characterized in that** the result of a test stimulus is loaded in one of the buffer memories and compressed prior to being forwarded to the test output (TDO).

4. Microchip according to one of the preceding claims, **characterized in that** the reconfigurable test structures is arranged for an in-field test.

5. Microchip according to one of the preceding claims, **characterized in that** the microchip is arranged for testing at least a portion of the multiplicity of reconfigurable test structures at the same time.

## Revendications

1. Micropuce comportant une pluralité de structures de test reconfigurables, dans laquelle la micropuce dispose d'une entrée de test (TDI) et d'une sortie de test (TDO), dans laquelle la pluralité de structures de test (DUT1 ... DUT3) peuvent être connectées à l'entrée de test (TDI) et l'entrée de sortie (TDO), **caractérisée en ce qu'**une mémoire tampon est prévue pour chacune de la pluralité de structures de test (DUT1 ... DUT3), dans laquelle la mémoire tampon contient des données de commande et des stimuli de test pendant le fonctionnement, dans laquelle chacune de la pluralité de structures de test peut être testée séparément et simultanément à l'aide de la mémoire tampon respective, dans laquelle chaque structure de test présente un instrument, dans laquelle une unité CIJTAG succède à l'instrument, qui contrôle le test réel dans la structure de test pertinente (DUT1 ... DUT3).

2. Micropuce selon la revendication 1, **caractérisée en ce qu'**un stimulus de test lu dans une des mémoires tampons est décompressé avant le traitement.

3. Micropuce selon la revendication 1 ou 2, **caractérisée en ce que** le résultat d'un stimulus de test est lu dans une des mémoires tampons et est compressé avant d'être transmis à la sortie de test (TDO).

4. Micropuce selon une des revendications précédentes, **caractérisée en ce que** la structure de test est adaptée à une utilisation dans un test sur le terrain.

5. Micropuce selon une des revendications précédentes, **caractérisée en ce que** la micropuce est conçue de telle sorte qu'au moins une partie de la pluralité de structures de test puisse être testée simultanément.
